(19) Europäisches Patentamt / European Patent Office / Office européen des brevets

(11) **EP 3 232 375 B1**

(12) **EUROPEAN PATENT SPECIFICATION**

(45) Date of publication and mention
of the grant of the patent:
**25.11.2020  Bulletin 2020/48**

(21) Application number: **15810884.5**

(22) Date of filing: **25.06.2015**

(51) Int Cl.:
**G06K 19/073** *(2006.01)*   **G01R 31/28** *(2006.01)*
**G06K 19/077** *(2006.01)*   **G06K 7/00** *(2006.01)*

(86) International application number:
**PCT/KR2015/006511**

(87) International publication number:
**WO 2015/199471 (30.12.2015 Gazette 2015/52)**

(54) **APPARATUS AND METHOD FOR INSPECTING SIDE CHANNELS OF COMBINED SMARTCARD**

VORRICHTUNG UND VERFAHREN ZUR INSPEKTION VON SEITENKANÄLEN FÜR KOMBINIERTE CHIPKARTE

APPAREIL ET PROCÉDÉ POUR INSPECTER DES CANAUX LATÉRAUX D'UNE CARTE INTELLIGENTE COMBINÉE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.06.2014   KR 20140078276**

(43) Date of publication of application:
**18.10.2017   Bulletin 2017/42**

(73) Proprietor: **Kookmin University Industry Academy Cooperation Foundation**
**Seoul 136-702 (KR)**

(72) Inventors:
• **KIM, Jin-Bae**
**Suwon-si**
**Gyeonggi-do 441-708 (KR)**
• **JI, Jae-Deok**
**Seongnam-si**
**Gyeonggi-do 463-882 (KR)**
• **HAN, Dong-Guk**
**Seoul 136-775 (KR)**

(74) Representative: **Groth & Co. KB**
**P.O. Box 6107**
**102 32 Stockholm (SE)**

(56) References cited:
**JP-A- 2005 085 269      KR-A- 20050 015 269**
**KR-A- 20050 054 774      KR-A- 20080 073 636**
**KR-A- 20110 060 569      KR-A- 20110 060 569**
**US-A1- 2012 228 391**

• **MESSERGES T S ET AL: "INVESTIGATIONS OF POWER ANALYSIS ATTACKS ON SMARTCARDS", USENIX WORKSHOP ON SMARTCARD TECHNOLOGY, XX, XX, 10 May 1999 (1999-05-10), pages 151-161, XP002905430,**

**Description**

**TECHNICAL FIELD**

The present invention relates to an apparatus and method for inspecting side channels of a combined smartcard. More particularly, the present invention relates to an apparatus and method for inspecting side channels of a combined smartcard, analyzing leaked power of the combined smartcard using both a contact terminal and a contactless RF circuit.

**DISCUSSION OF RELATED ART**

Smartcards are widely used in various fields, e.g., financial IC cards, mobile phones, and electronic passports. In particular, in financial IC cards, e.g., credit cards, "combined smartcards" which are of a type having both a contact terminal and a contactless RF communication means are widely used.

However, as the importance of security evaluation grows, the safety evaluation of side channel attacks on the combined smartcard has been strengthened.

A side channel attack is an attack method in which internal secret information, e.g., an encryption key, is acquired from the side channel by measuring physical characteristics such as execution time in communication, power consumption, and electromagnetic wave radiation.

Originally, a smartcard stores a secret key of a user inside the card in order to prevent forgery of the card and is operated by power supplied from an external power source. Since the smartcard performs the operation on the secret data every time it operates, there is a possibility that the side channel information regarding the power consumption is leaked at the time of the operation.

That is, when a side channel attack occurs, a user secret key may be estimated by performing a statistical process on observation data, e.g., power consumption, execution time measurement, and information using electromagnetic frequency radiation of a device in which an encryption algorithm of a smartcard is operated.

Generally, in systems using direct current power, a supply voltage is constant (constant voltage). Therefore, according to a power analysis method, which is one of methods for inspecting side channels, in order to analyze the power, a change amount of the current is measured and then multiplied by a constant voltage, as shown in Equation 1.

$$\text{Equation 1}$$

$$P\,(\text{power}) = V\,(\text{voltage}) \times I\,(\text{current})$$

Since instruments, such as a general oscilloscope, have difficulty in directly measuring current, a current-to-voltage converter is used to analyze the power in a power analysis.

In the conventional power analysis circuit, however, V (voltage) to be treated as a constant is distributed to the current-to-voltage converter and the smartcard connected to each other in series. Accordingly, when the consumption power of the smartcard is changed, the supply voltage is also affected.

When the resistance of the current-to-voltage converter decreases, a measured voltage weakens, which causes the problem of being vulnerable to noise inside or outside the circuit.

Conversely, when the resistance of the current-to-voltage converter increases, the supply voltage applied to the smartcard drops below the normal operating voltage, causing a problem, e.g., malfunction of a smartcard.

Meanwhile, electromagnetic attack which is one of side channel attack techniques is a method of analyzing leaked power due to electromagnetic emission.

Electromagnetic wave attack is a very effective side channel attack technique for a contactless smartcard, but it is difficult to precisely measure and analyze electromagnetic emission using a near-field probe according to the conventional technique.

KR 2011 0060569 represents the closest prior art for claims 1 and 10 and discloses prior art apparatus in the form a card reader of a side channel analyzer to efficiently perform side channel analysis based on leakage power signals.

US 2012/228391 discloses that a chip card receives and processes whatever combination of contact data and contact-less data is available to allow multiple functionalities for the chip card.

Messarges T S et. al.: "Investigations of power analysis attacks on smartcards", Usenix workshop on Smartcard technology, 10 May 1999, discloses actual results from monitoring smartcard power signals and introduces techniques that help maximize such side-channel information.

## DISCLOSURE OF INVENTION

### TECHNICAL PROBLEM

The present invention has been made in order to solve the above problems and aims to provide an apparatus and method for inspecting side channels of a combined smartcard, analyzing leaked power according to electromagnetic emission of the combined smartcard using both a contact terminal and a contactless RF circuit and avoiding a malfunction of the smartcard with insensitivity to noise of a circuit.

### SOLUTION TO PROBLEM

An apparatus for inspecting side channels of a combined smartcard according to an aspect of the present invention is characterized in that it configured to comprise a contactless inspection unit inductively coupling with a RF circuit of a combined smartcard to supply power to the combined smartcard and to communicate with the combined smartcard, a contact inspection unit connected to a part of contact terminals of the combined smartcard to measure an electromagnetic leakage signal of the combined smartcard, generated due to the inductive coupling; a signal analysis unit analyzing a waveform by receiving the electromagnetic leakage signal from the contact inspection unit, and a control unit controlling operations of the contactless inspection unit, the contact inspection unit, and the signal analysis unit.

Here, the contact inspection unit may further comprise a voltage level adjustor adjusting a voltage level of the electromagnetic leakage signal transmitted to the signal analysis unit

Further, the contact inspection unit may further comprise: an operational amplifier of which an inverting input terminal is connected to one of the contact terminals of the combined smartcard, a non-inverting input terminal is connected to a ground of the apparatus for inspecting side channels, and an operational amplifier output terminal is connected to an input terminal of the signal analysis unit, a fixed resistor of which one terminal is connected to the inverting input terminal, and the other terminal is connected to one of the input terminals of a variable resistor, and the variable resistor of which an output terminal is connected to the operational amplifier output terminal, and wherein the voltage level adjustor is the variable resistor

Furthermore, the voltage level adjustor may be the variable resistor.

Moreover, the contactless inspection unit may further comprise an antenna performing inductive coupling with the combined smartcard, an RF circuit communicating the combined smartcard through the antenna, a reader IC reading a signal received from the combined smartcard via the RF circuit; and a micro-control unit controlling operations of the RF circuit and the reader IC.

Further, the contact inspection unit may further comprise a constant voltage supplying unit to which 5 volts of input voltage is applied through an external USB terminal and applying positive power supply voltage and negative power supply voltage to the operational amplifier.

Furthermore, the constant voltage supplying unit may further comprise a DC-DC boost converter boosting the positive power supply voltage to have a value higher than the input voltage, and an inverting DC-DC boost converter boosting and inverting the negative power supply voltage so that the absolute value thereof is higher than the input voltage

Moreover, the signal analysis unit may be an oscilloscope connected to the control unit to transmit signal analysis result to the control unit.

Further, the control unit may be a host computer connected to the contactless inspection unit through an application protocol data unit (APDU), recording transition of the electromagnetic leakage signal, and performing inspection.

Furthermore, the reader IC may be an integrated circuit complying with the ISO/IEC 14443 standard

Moreover, the contact inspection unit may be connected to a Vcc terminal and a ground terminal of the contact terminal of the combined smartcard to measure voltage between the Vcc terminal and the ground terminal to be able to measure the electromagnetic leakage signal.

Meanwhile, a method for inspecting side channels according to another aspect of the present invention is characterized in that it comprises a step of operating a combined smartcard by a contactless inspection unit forming an inductive coupling with a RF circuit of the combined smartcard; a step of measuring an electromagnetic leakage signal of the combined smartcard, generated due to the inductive coupling by a contact inspection unit connected to a part of contact terminals of the combined smartcard; and a step of analyzing a waveform by the signal analyzing unit receiving the electromagnetic leakage signal from the contact inspection unit.

Here, the method may further comprise a step of adjusting a voltage level of the electromagnetic leakage signal transmitted to the signal analysis unit by the contact inspection unit.

Further, the method may further comprise a host computer connected to the contactless inspection unit 12 through an application protocol data unit (APDU) and a step of recording transition of the electromagnetic leakage signal.

Furthermore, the step of measuring the electromagnetic leakage signal may be configured to that the contact inspection is connected to a Vcc terminal and a ground terminal of the contact terminal of the combined smartcard to measure voltage between the Vcc terminal and the ground terminal, measuring the electromagnetic leakage signal.

## ADVANTAGEOUS EFFECTS OF INVENTION

The use of the present invention presents the effect to implement an apparatus and method for inspecting side channels of a combined smartcard, analyzing leaked power according to electromagnetic emission of the combined smartcard using both a contact terminal and a contactless RF circuit.

## BRIEF DESCRIPTION OF THE DRAWINGS

Fig. 1 is a block diagram illustrating an example of an apparatus inspecting side channels,

Fig. 2 is a block diagram more specifically illustrating a contact inspection unit of the apparatus inspecting side channels of Fig 1,

Fig. 3 is a block diagram more specifically illustrating a contactless inspection unit of the apparatus inspecting side channels of Fig 1,

Fig. 4 is a block diagram illustrating an example of a circuit applying constant voltage to the contact inspection unit of the apparatus inspecting side channels,

Fig. 5a is a graph illustrating a waveform for power measurement according to electromagnetic emission with an apparatus for inspecting side channels,

Fig. 5b is a graph illustrating a waveform to which the waveform for power measurement of Fig. 5 is low-pass filtered,

Fig. 5c is a graph illustrating correlation regarding eight encryption key values obtained by statistically analyzing the waveform of Fig. 5b with an apparatus for inspecting side channels,

Fig. 6a is a graph illustrating a waveform for power measurement for applying a conventional power analysis technique,

Fig. 6b is a graph illustrating a waveform to which the waveform for power measurement for applying a conventional power analysis technique is low-pass filtered,

Fig. 6c is a graph illustrating correlation regarding eight encryption key values obtained by statistically analyzing the waveform of Fig. 6b according to a conventional power analysis technique, and

Fig. 7 is a flowchart illustrating an example of a method for inspecting side channels.

## MODE FOR THE INVENTION

The present invention is based on the concept that in the case of a combined smartcard operated by power which is applied thereon with a contactless manner according to electromagnetic induction, a power change occurs at a contact terminal, and thus power consumption due to electromagnetic disturbance (EMD) may be measured through the contact terminal.

Hereinafter, embodiments of an apparatus and a method for inspecting side channels will be described in more detail with reference to drawings.

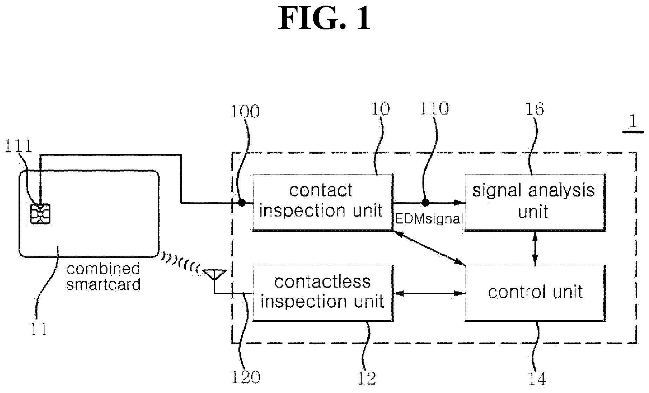

Fig. 1 is a block diagram illustrating an example of an apparatus inspecting side channels.

As illustrated in Fig. 1, an apparatus for inspecting side channels 1 is configured to comprise a contactless inspection unit 12, a contact inspection unit 10, a signal analysis unit 16, and a control unit 14.

The contactless inspection unit 12 inductivelycouples with a RF circuit of a combined smartcard 11 to supply power to the combined smartcard 11 and to communicate with the combined smartcard 11.

The contact inspection unit 10 is connected to a part of contact terminals 111 of the combined smartcard 11 to measure an electromagnetic leakage signal of the combined smartcard 11, generated due to inductive coupling.

The signal analysis unit 16 analyzes a waveform by receiving the electromagnetic leakage signal from the contact inspection unit 10.

The control unit 14 is connected to the contactless inspection unit 12, the contact inspection unit 10, and the signal analysis unit 16 to control their operations and to produce an analysis result.

In an embodiment of Fig. 1, the signal analysis unit 16 and the control unit 14 respectively are an oscilloscope and a host PC connected to the oscilloscope. Further, the contact inspection unit 10 is an inspection board connected to the host PC.

The method for inspecting side channels is performed by a manner connecting to the host PC to perform a cryptographic operation. For this, here, a cryptanalysis (key analysis) is performed through power consumption measured through the contact inspection unit 10.

This is based on the concept that although the combined smartcard is driven by a contactless operation by the contactless inspection unit 12, a power change occurs in contact terminals 111. For this, the apparatus for inspecting side channels connects jumpers to ports provided in the contactless inspection unit 12 (C1-C8).

According to the standard of contact communication, the functions of a total of eight individual contact terminals included in the contact terminals 111 are shown in Table 1

[Table 1]

| Terminal Number | Symbol | Function |
|---|---|---|
| C1 | Vcc | Supply Voltage |
| C2 | RST | Reset Input |
| C3 | CLK | Clock Input |
| C4 | AUX1 | Supplementary Contact |
| C5 | GND | Ground |
| C6 | Vpp | Programming Voltage |
| C7 | I/O | Input/Output for Serial Communication |
| C8 | AUX2 | Supplementary Contact |

During a contactless operation, electromagnetic leakage power consumption caused at the contact terminals 111 may be measured by connecting jumper of C1 to C8 to the ports 100 of the contact inspection unit 10 and then selecting a part of the individual contact terminals.

For example, the Vcc terminal C1 and the ground terminal C5 of the contact terminal of the combined smartcard are connected to the ports, voltage between the Vcc terminal and the ground terminalis measured, and thereby an electromagnetic leakage signal may be measured.

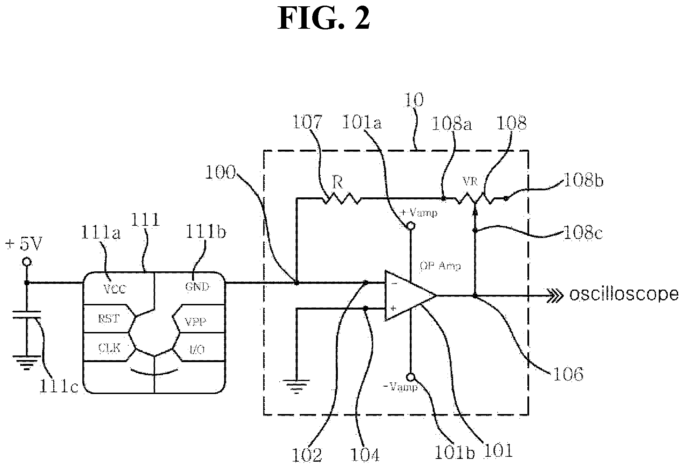

Fig. 2 is a block diagram more specifically illustrating the contact inspection unit of the apparatus inspecting side channels of Fig 1.

As illustrated in Fig. 2, the contact inspection unit 10 comprises an operational amplifier (OP AMP) 101, a fixed resistor 107, and a variable resistor 108.

An inverting input terminal 102 of the operational amplifier 101 is connected to one of the contact terminals 111 of the combined smartcard 11, and a non-inverting input terminal 104 is connected to ground side of the apparatus for inspecting side channels 1. Further, an operational amplifier output terminal 106 is connected to the signal analysis unit 16, i.e., an input terminal of the oscilloscope.

The operational amplifier 101 is preferably selected in consideration of the operating frequency characteristic of the smartcard 11 in order to minimize signal loss and distortion due to noise.

Further, one terminal 100 of the fixed resistor 107 is connected to the inverting input terminal 102, and the other terminal 108a is connected to one of the input terminals of the variable resistor 108. The output terminal 108c of the variable resistor 108 is connected to the operational amplifier output terminal 106.

The variable resistor 108 functions to adjust a voltage level output through the operational amplifier output terminal 106.

Referring back to Fig. 1, the contactless inspection unit 12 may adjust a size of the electromagnetic field applied to the combined smartcard.

For this, the contactless inspection unit 12 may further comprises an antenna, an RF circuit, a reader IC, and a micro-control unit.

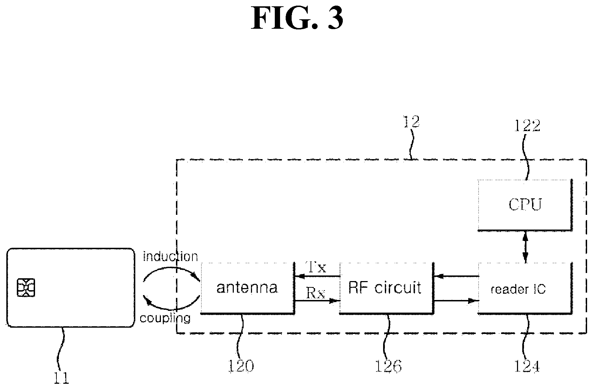

Fig. 3 is a block diagram more specifically illustrating the contactless inspection unit of the apparatus inspecting side channels of Fig 1.

As illustrated in Fig. 3, the antenna 120 of the contactless inspection unit 12 performs inductive coupling with the antenna mounted inside the combined smartcard 11.

The RF circuit 126 drives the combined smartcard 11 by supplying power to the combined smartcard 11 through the antenna 120 in a contactless manner.

The reader IC 124 reads a signal received from the combined smartcard 11 via the RF circuit 126. In this embodiment, the reader IC is an integrated circuit complying with the ISO/IEC 14443 standard regarding a contactless IC card. The reader IC 124 measures an electromagnetic leakage signal and performs modulation and demodulation.

The micro-control unit 122 controls operations of the RF circuit 126 and the reader IC 124. Further, it performs communication with the control unit 14 connected to the contactless inspection unit 12, i.e., with the host PC.

Meanwhile, in order to secure the stability of the contactless operation of the combined smartcard 11, the apparatus for inspecting side channels 1 is necessary to apply a stable positive power supply voltage (+ Vamp) and negative power supply voltage (- Vamp) to the operational amplifier 101 of the contact inspection unit 10.

As described above with reference to Equation 1, as V (voltage) to be treated as a constant in the power analysis circuit is distributed to the current-to-voltage converter and the smartcard connected to each other in series, when the power consumption of the smartcard changes, it also affects the supply voltage.

When the resistance value of the current-to-voltage converter is decreased, the voltage to be measured is weaker, which causes a problem of being vulnerable to noise inside or outside the circuit. Therefore, the resistance value of the current-to-voltage converter should be taken to a value not smaller.

In this case, due to a large resistance value of the current-to-voltage converter, the supply voltage applied to the smartcard may drop below the normal operating voltage, resulting in a problem, e.g., malfunction of the smartcard.

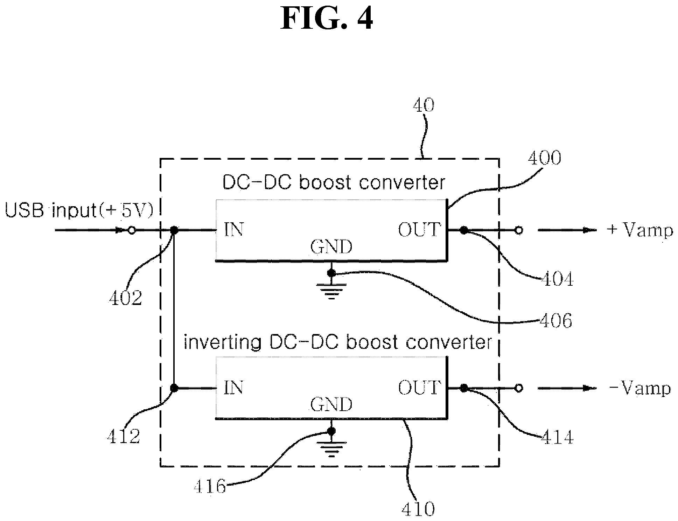

Fig. 4 is a block diagram illustrating an example of a circuit applying constant voltage to the contact inspection unit of the apparatus inspecting side channels.

A constant voltage supply unit 40 exemplified in Fig. 4 applies stable power source voltage to two power source voltage terminals 101a and 101b of the operating amplifier 101 of the apparatus for inspecting side channels 1.

To this end, the constant voltage supply unit 40 includes an input terminal 402 to which a 5-volt (V) of input voltage is applied through an external USB terminal. The input voltage is boosted by a DC-DC boost converter 400, and thus the positive power supply voltage (+ Vamp) has a value higher than the input voltage, and then is applied to the terminal 101a connected to an output terminal 404. Similarly, the input voltage is boosted and inverted in an inverting DC-DC boost converter 410, and thus the absolute value of the negative power supply voltage (-Vamp) is higher than the input voltage, and then is applied to the terminal 101b connected an output terminal 444. Ground terminals 406 and 416 of the DC-DC boost converter 400 and the inverting DC-DC boost converter 410 respectively are grounded to the ground terminals of the apparatus for inspecting side channels 1.

The characteristic of the constant voltage supply unit 40 of Fig. 4 is that it may be simply and inexpensively implemented using a USB output terminal that may be easily obtained from a host PC or the like.

Meanwhile, ripple noise during operation may be reduced by comprising an LC filter suitable for the constant voltage supply unit 40 and the peripheral circuit of Fig. 4. A method of reducing ripple noise by comprising an LC filter is widely known, so a detailed description thereof is excluded.

Through the constant voltage supply unit 40 of Fig. 4, the resolution (potential difference) of the output terminal of the operational amplifier 101 may be greatly increased from about 10 mV of a conventional level to 100 mV to 1000 mV level. Furthermore, the power supply voltage applied to the smartcard may be maintained at 5V while greatly improving the resolution.

Meanwhile, as described above, the signal analysis unit is implemented using the oscilloscope.

The functional block of a typical oscilloscope generally comprises a probe and an amplifier for signal measurement, a clock generator for generating time information, an analog to digital converter, and an internal memory for signal storage.

Simply, it comprises (1) a probe or signal input terminal for measuring an external signal, (2) an ADC converter for converting an analog signal to a digital signal, (3) an internal buffer memory capable of storing a converted signal, and (4) an output function block capable of reading a value stored in the memory.

The signal analysis unit 16 of the apparatus inspecting side channels 1, i.e., the oscilloscope, is connected to the control unit 14, i.e., the host PC, and transmits the signal analysis result to the control unit 14.

The control unit 14 is connected to the contactless inspection unit 12 through an application protocol data unit (APDU), records transition of the electromagnetic leakage signal, and performs inspection.

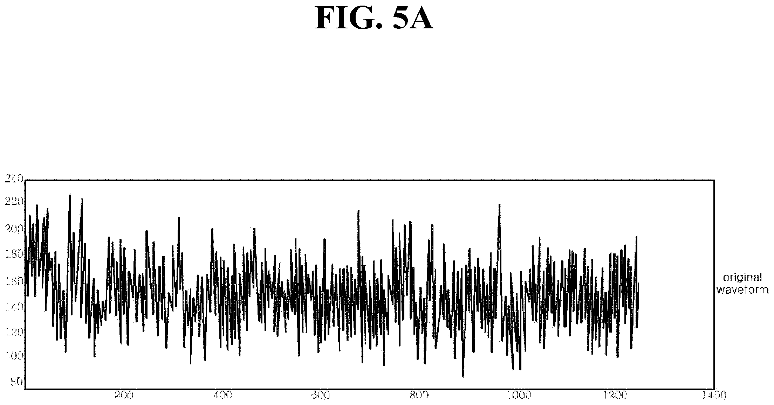

Fig. 5a is a graph illustrating a waveform for power measurement according to electromagnetic emission.

The waveform exemplified in Fig 5a represents the variation of the voltage value between the terminal C1 and the terminal C5 of the smartcard, collected through the input terminal 100 of the contact inspection unit 10 when the combined smartcard 11 is operated according to electromagnetic induction of contactless inspection unit 12.

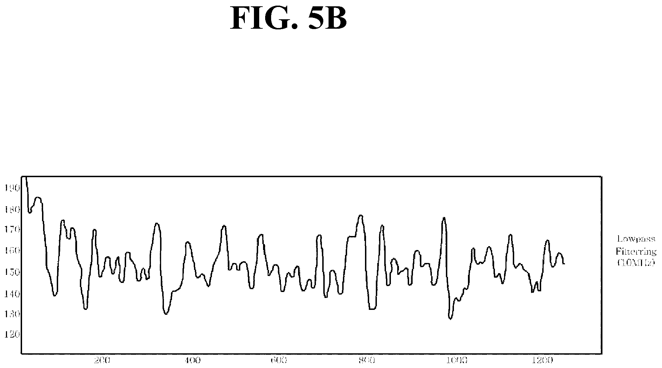

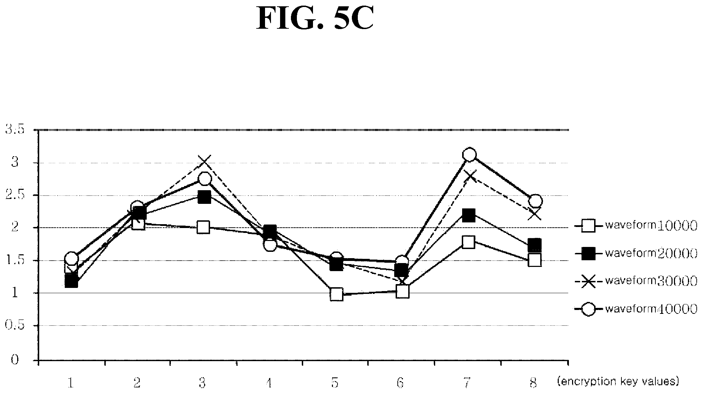

Fig. 5b is a graph illustrating a waveform to which the waveform for power measurement of Fig. 5 is low-pass filtered.

As illustrated in Fig. 5b, upon operating low-pass filtering, a high frequency component is eliminated, and thus it is possible to apply correlation power analysis (CPA).

Fig. 5c is a graph illustrating correlation regarding eight encryption key values obtained by statistically analyzing the waveform of Fig. 5b with the apparatus for inspecting side channels.

Fig. 5c shows statistical correlation values when analyzing 10,000, 20,000, 30,000, and 40,000 waveforms of eight encryption key values.

When correlation value for a certain key value is 1.25 or more, it may be considered that the key value is found. According to Fig. 5c, it may be seen that even if only about 20,000 (relatively small) waveforms are analyzed, all of eight encryption key values of a user secret key stored in the smartcard 11 may be found.

Table 2 is a table summarizing the correlation values according to the G function and the number of waveforms used in Fig. 5c.

[Table 2]

| Number of waveforms | K01-1st G function | | | | K02-2nd G function | | | |
|---|---|---|---|---|---|---|---|---|
| | 1(159) | 2(29) | 3(100) | 4(113) | 1(186) | 2(173) | 3(225) | 4(54) |
| 10000 | 1.37 | 2.11 | 2.06 | 2.00 | *1.08* | *1.14* | 1.91 | 4.65 |
| 20000 | 1.22 | 2.28 | 2.53 | 1.97 | 1.55 | 1.48 | 2.30 | 1.87 |
| 30000 | 1.59 | 2.29 | 3.04 | 1.94 | 1.62 | 1.27 | 2.91 | 2.35 |
| 40000 | 1.55 | 2.36 | 2.81 | 1.83 | 1.62 | 1.60 | 3.25 | 2.54 |

In Table 2, each item represents the correlation value corresponding to the number of waveforms and the G function.

Correlation values exceeding 1.25 were obtained except for the values in italics ("1.08" and "1.14" in the case of 10,000 waveforms). Therefore, as per the apparatus for inspecting side channels according to the present invention, it may be determined that all of the encryption key values may be found even if only 20,000 waveforms are analyzed.

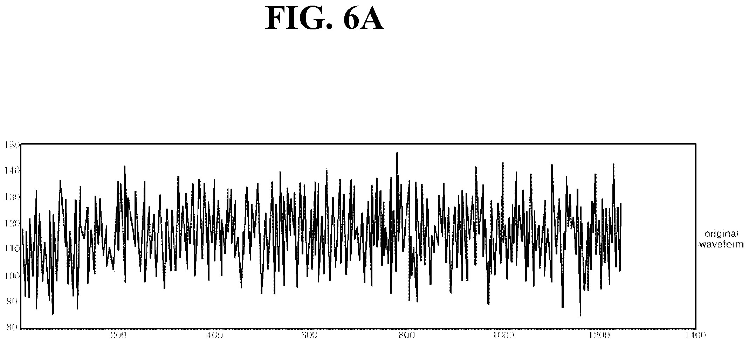

This may be confirmed by comparison with an extraction result of the encryption key value according to a conventional power analysis technique illustrated in Figs. 6a to 6c.

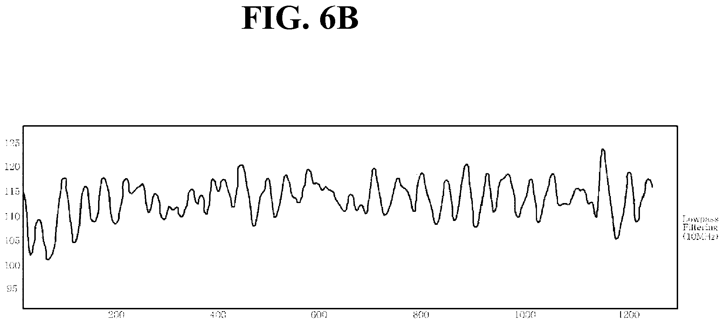

Fig. 6a is a graph illustrating a waveform for power measurement for applying the conventional power analysis technique, and Fig. 6b is a graph illustrating a waveform to which the waveform of Fig. 6a is low-pass filtered.

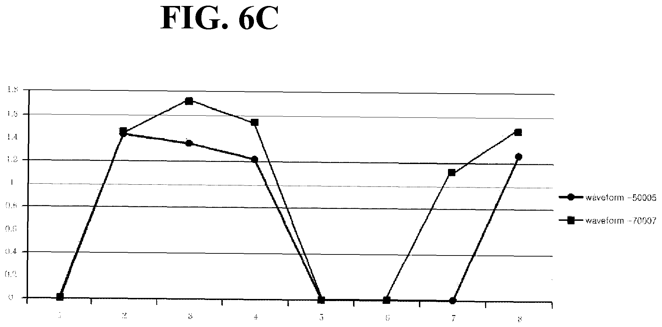

Further, Fig. 6c is a graph illustrating correlation regarding eight encryption key values obtained by statistically analyzing the waveform of Fig. 6b according to the conventional power analysis technique.

As illustrated in Fig. 6c, in the conventional power analysis technique, when about 50,000 waveforms are analyzed, it may be seen that the first, fifth, sixth, and seventh key values are not normally extracted. Moreover, only when about 70,000 waveforms are analyzed, it may be seen that the first, fifth, and sixth key values are not still normally extracted.

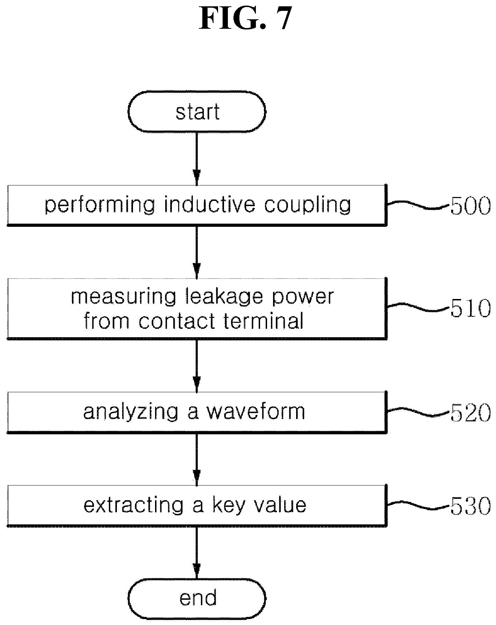

Fig. 7 is a flowchart illustrating a method for inspecting side channels of the combined smartcard using the apparatus for inspecting side channels.

The method for inspecting side channels illustrated in Fig. 7 is generally performed comprising three steps as follow.

- a step of operating a combined smartcard by a contactless inspection unit forming an inductive coupling with a RF circuit of the combined smartcard 500,

- a step of measuring an electromagnetic leakage signal of the combined smartcard, generated due to inductive coupling when a contact inspection unit is connected to a part of contact terminals of the combined smartcard 510, and

- a step of analyzing a waveform by the signal analyzing unit receiving the electromagnetic leakage signal from the contact inspection unit 520 are them.

In addition, the method may further comprise a step of extracting a key value, by a control unit to statistically apply the CPA technique to the analysis result received from the signal analysis unit 530.

Meanwhile, the method may further comprise a step of adjusting, by a contact inspection unit, a voltage level of an electromagnetic leakage signal transmitted to a signal analysis unit. It may be performed by adjusting a size of the variable resistor by the contact inspection unit.

The apparatus and method for inspecting side channels of the combined smartcard as described above are not limited to the configuration and method of the embodiments described in the specification.

Further, it should be noted that the embodiments, as described above, are merely to illustrate the invention and are not intended to limit the invention. It will be appreciated that various embodiments are possible within the scope of the technical concept by those of ordinary skill in the art regarding the field of a contact and a contactless smartcards and a technique for inspecting side channels.

Moreover, the apparatus and the method for inspecting side channels of a combined smartcard as described above may be implemented by storing commands for executing a method on a computer-readable recording medium. Examples of the computer-readable recording medium widely include various known recording media, e.g., ROM, RAM, CD-ROM, magnetic tape, floppy disk, optical data storage device, solid state drive.

**Claims**

1. An apparatus for inspecting a side channel of a combined smartcard,
   **characterized in that** said apparatus comprising:

   a contactless inspection unit (12) inductively coupling with a RF circuit of a combined smartcard to supply power to the combined smartcard and to communicate with the combined smartcard;
   a contact inspection unit (10) connected to a part of contact terminals (111) of the combined smartcard to measure an electromagnetic leakage signal of the combined smartcard, generated due to the inductive coupling;
   a signal analysis unit (16) analyzing a waveform by receiving the electromagnetic leakage signal from the contact inspection unit; and
   a control unit (14) controlling operations of the contactless inspection unit, the contact inspection unit and the signal analysis unit.

2. The apparatus for inspecting side channel of a combined smartcard of claim 1, wherein the contact inspection unit (10) further comprises a voltage level adjustor adjusting a voltage level of the electromagnetic leakage signal transmitted to the signal analysis unit (16).

3. The apparatus for inspecting side channel of a combined smartcard of claim 2, wherein the contact inspection unit (10) further comprises:

   an operational amplifier (101) of which an inverting input terminal (102) is connected to one of the contact terminals (111) of the combined smartcard, a non-inverting input terminal (104) is connected to a ground of the apparatus for inspecting side channels, and an operational amplifier output terminal (106) is connected to an input terminal (104) of the signal analysis unit (16);
   a fixed resistor (107) of which one terminal is connected to the inverting input terminal (102), and the other terminal is connected to one of the input terminals of a variable resistor; and
   the variable resistor (108) of which an output terminal (108C) is connected to the operational amplifier output terminal (106), and wherein the voltage level adjustor is the variable resistor.

4. The apparatus for inspecting side channel of a combined smartcard of claim 1, wherein the contactless inspection unit (12) further comprises:

   an antenna (120) performing inductive coupling with the combined smartcard;
   an RF circuit (126) communicating the combined smartcard through the antenna;
   a reader IC (124) reading a signal received from the combined smartcard via the RF circuit; and
   a micro-control unit (122) controlling operations of the RF circuit and the reader IC.

5. The apparatus for inspecting side channel of a combined smartcard of claim 3, wherein the contact inspection unit (10) further comprises a constant voltage supplying unit to which 5 volts of input voltage is applied through an external USB terminal and applying positive power supply voltage and negative power supply voltage to the operational amplifier (101), and wherein the constant voltage supplying unit further comprises: a DC-DC boost converter boosting the positive power supply voltage to have a value higher than the input voltage; and an inverting DC-DC boost converter boosting and inverting the negative power supply voltage so that the absolute value thereof is higher than the input voltage.

6. The apparatus for inspecting side channel of a combined smartcard of claim 1, wherein the signal analysis unit (16) is an oscilloscope connected to the control unit (14) to transmit signal analysis result to the control unit.

7. The apparatus for inspecting side channel of a combined smartcard of claim 1, wherein the control unit (14) is a host computer connected to the contactless inspection unit (12) through an application protocol data unit (APDU), recording transition of the electromagnetic leakage signal, and performing inspection.

8. The apparatus for inspecting side channel of a combined smartcard of claim 4, wherein the reader IC (124) is an integrated circuit complying with the ISO/IEC 14443 standard.

9. The apparatus for inspecting side channel of a combined smartcard of claim 1, wherein the contact inspection unit is connected to a Vcc terminal and a ground terminal of the contact terminal of the combined smartcard to measure voltage between the Vcc terminal and the ground terminal, measuring the electromagnetic leakage signal.

10. A method for inspecting side channel of a combined smartcard,
    **characterized in that** said method comprising:

    a step of operating a combined smartcard by a contactless inspection unit forming an inductive coupling with a RF circuit of the combined smartcard;
    a step of measuring an electromagnetic leakage signal of the combined smartcard, generated due to the inductive coupling by a contact inspection unit connected to a part of contact terminals of the combined smartcard; and
    a step of analyzing a waveform by the signal analyzing unit receiving the electromagnetic leakage signal from the contact inspection unit.

11. The method for inspecting side channel of a combined smartcard of claim 10, further comprising a step of adjusting a voltage level of the electromagnetic leakage signal transmitted to the signal analysis unit by the contact inspection unit.

12. The method for inspecting side channel of a combined smartcard of claim 10, further comprising a host computer connected to the contactless inspection unit (12) through an application protocol data unit (APDU) and a step of recording transition of the electromagnetic leakage signal.

13. The method for inspecting side channel of a combined smartcard of claim 10, wherein the step of measuring the electromagnetic leakage signal is configured to that the contact inspection is connected to a Vcc terminal and a ground terminal of the contact terminal of the combined smartcard to measure voltage between the Vcc terminal and the ground terminal, measuring the electromagnetic leakage signal.

**Patentansprüche**

1. Vorrichtung zur Inspektion eines Seitenkanals einer kombinierten Chipkarte,
   **dadurch gekennzeichnet dass** die Vorrichtung umfasst:

   eine kontaktlose Inspektionseinheit (12), die induktiv mit einem HF-Schaltkreis einer kombinierten Chipkarte gekoppelt ist, um die kombinierte Chipkarte mit Strom zu versorgen und mit der kombinierten Chipkarte zu kommunizieren;
   eine Kontaktinspektionseinheit (10), die mit einem Teil der Kontaktanschlüsse (111) der kombinierten Chipkarte verbunden ist, um ein elektromagnetisches Lecksignal der kombinierten Chipkarte zu messen, das aufgrund der induktiven Kopplung erzeugt wird;
   eine Signalanalyseeinheit (16), die eine Wellenform durch Empfangen des elektromagnetischen Lecksignals von der Kontaktinspektionseinheit analysiert; und
   eine Steuereinheit (14), die den Betrieb der kontaktlosen Inspektionseinheit, der Kontaktinspektionseinheit und der Signalanalyseeinheit steuert.

2. Vorrichtung zur Inspektion des Seitenkanals einer kombinierten Chipkarte nach Anspruch 1, wobei die Kontaktinspektionseinheit (10) ferner einen Spannungspegeleinsteller umfasst, der einen Spannungspegel des elektromagnetischen Lecksignals einstellt, das an die Signalanalyseeinheit (16) übertragen wird.

3. Vorrichtung zur Inspektion des Seitenkanals einer kombinierten Chipkarte nach Anspruch 2, wobei die Kontaktinspektionseinheit (10) ferner umfasst:

einen Operationsverstärker (101), von dem ein invertierender Eingangsanschluss (102) mit einem der Kontaktanschlüsse (111) der kombinierten Chipkarte verbunden ist, ein nichtinvertierender Eingangsanschluss (104) mit einer Masse der Vorrichtung zur Inspektion von Seitenkanälen verbunden ist, und ein Operationsverstärker-Ausgangsanschluss (106) mit einem Eingangsanschluss (104) der Signalanalyseeinheit (16) verbunden ist; einen Festwiderstand (107), von dem ein Anschluss mit dem invertierenden Eingangsanschluss (102) und der andere Anschluss mit einem der Eingangsanschlüsse eines variablen Widerstandes verbunden ist; und den variablen Widerstand (108), von dem ein Ausgangsanschluss (108C) mit dem Ausgangsanschluss (106) des Operationsverstärkers verbunden ist, und wobei der Spannungpegeleinsteller der variable Widerstand ist.

4. Vorrichtung zur Inspektion des Seitenkanals einer kombinierten Chipkarte nach Anspruch 1, wobei die kontaktlose Inspektionseinheit (12) ferner umfasst:

eine Antenne (120), die eine induktive Kopplung mit der kombinierten Chipkarte durchführt; einen HF-Schaltkreis (126), der die kombinierte Chipkarte über die Antenne kommuniziert; einen Lese-IC (124), der ein von der kombinierten Chipkarte über den HF-Schaltkreis empfangenes Signal liest; und eine Mikrosteuereinheit (122), die den Betrieb des HF-Schaltkreises und des Lese-ICs steuert.

5. Vorrichtung zur Inspektion des Seitenkanals einer kombinierten Chipkarte nach Anspruch 3, wobei die Kontaktinspektionseinheit (10) ferner eine Konstantspannungsversorgungseinheit, an die 5 Volt Eingangsspannung durch einen externen USB-Anschluss angelegt werden und die eine positive Versorgungsspannung und eine negative Versorgungsspannung an den Operationsverstärker (101) anlegt, umfasst, und wobei die Konstantspannungsversorgungseinheit ferner umfasst: einen DC-DC-Aufwärtswandler, der die positive Stromversorgungsspannung auf einen Wert anhebt, der höher als die Eingangsspannung ist; und einen invertierenden DC-DC-Aufwärtswandler, der die negative Stromversorgungsspannung anhebt und invertiert, so dass deren absoluter Wert davon höher als die Eingangsspannung ist.

6. Vorrichtung zur Inspektion des Seitenkanals einer kombinierten Chipkarte nach Anspruch 1, wobei die Signalanalyseeinheit (16) ein Oszilloskop ist, das mit der Steuereinheit (14) verbunden ist, um das Ergebnis der Signalanalyse an die Steuereinheit zu übertragen.

7. Vorrichtung zur Inspektion des Seitenkanals einer kombinierten Chipkarte nach Anspruch 1, wobei die Steuereinheit (14) ein Host-Computer ist, der durch eine Anwendungsprotokoll-Dateneinheit (APDU) mit der kontaktlosen Inspektionseinheit (12) verbunden ist, den Übergang des elektromagnetischen Lecksignals aufzeichnet und die Inspektion durchführt.

8. Vorrichtung zur Inspektion des Seitenkanals einer kombinierten Chipkarte nach Anspruch 4, wobei der Lese-IC (124) ein integrierter Schaltkreis ist, der der Norm ISO/IEC 14443 entspricht.

9. Vorrichtung zur Inspektion des Seitenkanals einer kombinierten Chipkarte nach Anspruch 1, wobei die Kontaktinspektionseinheit mit einem Vcc-Anschluss und einem Erdungsanschluss des Kontaktanschlusses der kombinierten Chipkarte verbunden ist, um die Spannung zwischen dem Vcc-Anschluss und dem Erdungsanschluss zu messen, wobei das elektromagnetische Lecksignal gemessen wird.

10. Verfahren zur Inspektion eines Seitenkanals einer kombinierten Chipkarte, **dadurch gekennzeichnet dass** das Verfahren umfasst:

ein Schritt des Betriebs einer kombinierten Chipkarte durch eine kontaktlose Inspektionseinheit, die eine induktive Kopplung mit einem HF-Schaltkreis der kombinierten Chipkarte bildet; einen Schritt des Messens eines elektromagnetischen Lecksignals der kombinierten Chipkarte, das aufgrund der induktiven Kopplung durch eine Kontaktinspektionseinheit erzeugt wird, die mit einem Teil der Kontaktanschlüsse der kombinierten Chipkarte verbunden ist; und einen Schritt des Analysierens einer Wellenform durch die Signalanalyseeinheit, die das elektromagnetische Lecksignal von der Kontaktinspektionseinheit empfängt.

**11.** Verfahren zur Inspektion des Seitenkanals einer kombinierten Chipkarte nach Anspruch 10, ferner umfassend einen Schritt des Einstellens eines Spannungspegels des elektromagnetischen Lecksignals, das von der Kontaktinspektionseinheit an die Signalanalyseeinheit übertragen wird.

**12.** Verfahren zur Inspektion des Seitenkanals einer kombinierten Chipkarte nach Anspruch 10, ferner umfassend einen Host-Computer, der über eine Anwendungsprotokoll-Dateneinheit (APDU) mit der kontaktlosen Inspektionseinheit (12) verbunden ist, und einen Schritt zur Aufzeichnung des Übergangs des elektromagnetischen Lecksignals.

**13.** Verfahren zur Inspektion des Seitenkanals einer kombinierten Chipkarte nach Anspruch 10, wobei der Schritt des Messens des elektromagnetischen Lecksignals dazu ausgelegt ist, dass die Kontaktinspektion mit einem Vcc-Anschluss und einem Erdungsanschluss des Kontaktanschlusses der kombinierten Chipkarte verbunden wird, um die Spannung zwischen dem Vcc-Anschluss und dem Erdungsanschluss zu messen, wobei das elektromagnetische Lecksignal gemessen wird.

**Revendications**

**1.** Appareil d'inspection d'un canal latéral d'une carte intelligente combinée,
**caractérisé en ce que** ledit appareil comprend :

une unité d'inspection sans contact (12) qui se couple de manière inductive à un circuit RF d'une carte intelligente combinée pour alimenter en puissance une carte intelligente combinée et communiquer avec la carte intelligente combinée ;
une unité d'inspection avec contact (10) connectée à une partie de terminaux de contact (111) de la carte intelligente combinée pour mesurer un signal de fuite électromagnétique de la carte intelligente combinée, généré en raison du couplage inductif ;
une unité d'analyse de signal (16) qui analyse une forme d'onde en recevant le signal de fuite électromagnétique à partir de l'unité d'inspection avec contact ; et
une unité de commande (14) qui commande les opérations de l'unité d'inspection sans contact, l'unité d'inspection avec contact et l'unité d'analyse de signal.

**2.** Appareil d'inspection d'un canal latéral d'une carte intelligente combinée selon la revendication 1, dans lequel l'unité d'inspection avec contact (10) comprend en outre un ajusteur de niveau de tension qui ajuste un niveau de tension du signal de fuite électromagnétique transmis à l'unité d'analyse de signal (16).

**3.** Appareil d'inspection d'un canal latéral d'une carte intelligente combinée selon la revendication 2, dans lequel l'unité d'inspection avec contacts (10) comprend en outre :

un amplificateur opérationnel (101) dont une borne d'entrée inverse (102) est connectée à un des terminaux de contact (111) de la carte intelligente combinée, une borne d'entrée non inverseuse (104) est connectée à une masse de l'appareil pour inspecter des canaux latéraux, et une borne de sortie d'amplificateur opérationnel (106) est connectée à une borne d'entrée (104) de l'unité d'analyse de signal (16) ;
une résistance fixe (107) dont une bornée est connectée à la borne d'entrée inverse (102), et l'autre borné est connectée à une des bornes d'entrée d'une résistance variable ; et
la résistance variable (108) dont une borne de sortie (108C) est connectée à la borne de sortie d'amplificateur opérationnel (106), l'ajusteur de niveau de tension étant la résistance variable.

**4.** Appareil d'inspection d'un canal latéral d'une carte intelligente combinée selon la revendication 1, dans lequel l'unité d'inspection sans contact (12) comprend en outre :

une antenne (120) qui réalise un couplage inductif avec la carte intelligente combinée ;
un circuit RF (126) qui communique avec la carte intelligente combinée par le biais de l'antenne ;
un circuit intégré de lecteur (124) qui est un signal reçu à partir de la carte intelligente combinée par l'intermédiaire du circuit RF ; et
une unité de microcommande (122) qui commande des opérations du circuit RF et du circuit intégré de lecteur.

**5.** Appareil d'inspection d'un canal latéral d'une carte intelligente combinée selon la revendication 3, dans lequel l'unité d'inspection avec contact (10) comprend en outre une unité d'alimentation de tension constante à laquelle 5 volts de tension d'entrée sont appliqués par le biais d'une borne USB externe et appliquant une tension d'alimentation électrique positive et une tension d'alimentation électrique négative à l'amplificateur opérationnel (101), et dans lequel l'unité d'alimentation de tension constante comprend en outre : un convertisseur amplificateur C.C.-C.C. qui amplifie la tension d'alimentation électrique positive à une valeur supérieure à la tension d'entrée ; et un convertisseur amplificateur C.C.-C.C. inverseur qui amplifie et inverse la tension d'alimentation électrique négative de telle sorte que sa valeur absolue soit supérieure à la tension d'entrée.

6. Appareil d'inspection d'un canal latéral d'une carte intelligente combinée selon la revendication 1, dans lequel l'unité d'analyse de signal (16) est un oscilloscope connecté à l'unité de commande (14) pour transmettre un résultat d'analyse de signal à l'unité de commande.

7. Appareil d'inspection d'un canal latéral d'une carte intelligente combinée selon la revendication 1, dans lequel l'unité de commande (14) est un ordinateur hôte connecté à l'unité d'inspection sans contact (12) par le biais d'une unité de données de protocole d'application (APDU), qui enregistre la transition du signal de fuite électromagnétique et effectue une inspection.

8. Appareil d'inspection d'un canal latéral d'une carte intelligente combinée selon la revendication 4, dans lequel le circuit intégré de lecteur (124) est un circuit intégré conforme à la norme ISO/IEC 14443.

9. Appareil d'inspection d'un canal latéral d'une carte intelligente combinée selon la revendication 1, dans lequel l'unité d'inspection avec contact est connectée à une borne Vcc et une borne de masse du terminal de contact de la carte intelligente combinée pour mesurer une tension entre la borne Vcc et la borne de masse, mesurant le signal de fuite électromagnétique.

10. Procédé d'inspection d'un canal latéral d'une carte intelligente combinée,
**caractérisé en ce que** ledit procédé comprend :

une étape d'actionnement de la carte intelligente combinée par une unité d'inspection sans contact formant un couplage inductif avec un circuit RF de la carte intelligente combinée ;
une étape de mesure de signal de fuite électromagnétique de la carte intelligente combinée, généré en raison du couplage inductif par une unité d'inspection avec contact connectée à une partie de terminaux de contact de la carte intelligente combinée ; et
une étape d'analyse d'une forme d'onde par l'unité d'analyse de signal qui reçoit le signal de fuite électromagnétique à partir de l'unité d'inspection avec contact.

11. Procédé d'inspection d'un canal latéral d'une carte intelligente combinée selon la revendication 10, comprenant en outre une étape d'ajustement d'un niveau de tension du signal de fuite électromagnétique transmis à l'unité d'analyse de signal par l'unité d'inspection de contact.

12. Procédé d'inspection d'un canal latéral d'une carte intelligente combinée selon la revendication 10, comprenant en outre un ordinateur hôte connecté à l'unité d'inspection sans contact (12) par le biais d'une unité de données de protocole d'application (APDU) et une étape d'enregistrement d'une transition du signal de fuite électromagnétique.

13. Procédé d'inspection d'un canal latéral d'une carte intelligente combinée selon la revendication 10, dans lequel l'étape de mesure du signal de fuite électromagnétique est configurée de telle sorte que l'inspection avec contact soit connectée à une borne Vcc et à une borne de masse du terminal de contact de la carte intelligente combinée pour mesurer une tension entre la borne Vcc et la borne de masse, mesurant le signal de fuite électromagnétique.

# FIG. 1

# FIG. 2

# FIG. 3

# FIG. 4

# FIG. 5A

original
waveform

**FIG. 5B**

FIG. 5C

# FIG. 6A

original waveform

EP 3 232 375 B1

EP 3 232 375 B1

# FIG. 6B

Lowpass Filtering (10MHz)

# FIG. 6C

# FIG. 7

```
          ( start )
              │
              ▼
┌──────────────────────────────┐
│ performing inductive coupling │ ─── 500
└──────────────────────────────┘
              │
              ▼
┌──────────────────────────────┐
│     measuring leakage power   │
│     from contact terminal     │ ─── 510
└──────────────────────────────┘
              │
              ▼
┌──────────────────────────────┐
│      analyzing a waveform     │ ─── 520
└──────────────────────────────┘
              │
              ▼
┌──────────────────────────────┐
│      extracting a key value   │ ─── 530
└──────────────────────────────┘
              │
              ▼
           ( end )
```

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 20110060569

- US 2012228391 A

### Non-patent literature cited in the description

- **MESSARGES T S.** Investigations of power analysis attacks on smartcards. *Usenix workshop on Smartcard technology,* 10 May 1999